# EUROPÄISCHE PATENTSCHRIFT

(11) **EP 2 247 766 B1**
(45) Veröffentlichungstag und Bekanntmachung des Hinweises auf die Patenterteilung: **14.08.2013**
(21) Anmeldenummer: 08872983.5
(22) Anmeldetag: 10.12.2008
(51) Int. Cl.: C23C 14/04, C23C 4/02

(54) **VERFAHREN ZUR HERSTELLUNG STRUKTURIERTER OBERFLÄCHEN**
METHOD FOR PRODUCING STRUCTURED SURFACES
PROCÉDÉ POUR PRODUIRE DES SURFACES STRUCTURÉES

(30) Priorität: 26.02.2008 DE 102008011249
(43) Veröffentlichungstag der Anmeldung: 10.11.2010
(73) Patentinhaber: Maschinenfabrik Reinhausen GmbH, 93059 Regensburg (DE)
(72) Erfinder: BISGES, Michael, 93161 Sinzing (DE); HARTMANN, Uwe, 32805 Horn-Bad-Meinberg (DE)
(86) Internationale Anmeldenummer: PCT/EP2008/010451
(87) Internationale Veröffentlichungsnummer: WO 2009/106113

(56) Entgegenhaltungen:
- DE-A1- 3 924 716
- JP-A- 11 214 272
- US-A- 4 720 315
- US-A- 5 130 163

## Beschreibung

Die Erfindung betrifft ein Verfahren zur Herstellung strukturierter Oberflächen, d. h. Muster auf einem Substrat mittels Plasmabeschichtung.

Es ist bereits bekannt, mittels verschiedenster Plasmabeschichtungsverfahren strukturierte Beschichtungen auf Substraten herzustellen. Diese werden meist dazu benutzt, Schichtdicken von weit mehr als 30 µm zu produzieren. Dazu muss ein geeignetes Maskierungsverfahren zur Aufprägung des Beschichtungsmusters eingesetzt werden. Bei der Plasmabeschichtung liegt eine Besonderheit darin, dass das im Plasma erhitzte Beschichtungsmedium, wie Pulver oder Aerosol, großflächig aus der Düse austritt und gleichzeitig auch als verdampftes Material (Nanopartikel) vorliegen kann. Durch den Strömungsdruck unterwandern diese Nanopartikel die heute üblichen aufliegenden Schablonen am Rand, allein schon verursacht durch die Oberflächenrauhigkeit des Substrats.

Weiterhin bekannt ist es, mit gedruckten Masken zu arbeiten; dabei entsteht eine vollflächig geschlossene Beschichtung auf den Maskenstrukturen, und ein gezieltes Ablösen ist nicht mehr oder doch zumindestens nur unter Schwierigkeiten möglich.

Als Masken kommen beim Stand der Technik in der Regel biegeschlaffe Materialien zum Einsatz, die nicht in der Lage sind, die jeweiligen Maskierungskanten mit einer definierten Anpresskraft vorzuspannen, was das weiter oben erläuterte Unterwandern der Konturen verstärkt.

Weiterhin ist es bereits bekannt, eine Schablonenmaskierung mittels Laserschablonen vorzunehmen, die mittels Vakuum angepresst werden kann. Dieses Verfahren erfordert allerdings Bohrungen im Substrat, zudem sind nur bestimmte Strukturen realisierbar, da die Schablone eine bestimmte geometrische und innere Steifigkeit zur Handhabung benötigt.

Schließlich sind die beispielsweise von der Leiterplattenherstellung bekannten Photoresist-Verfahren bekannt, bei denen der Photoresist aufgedruckt und anschließend mit einer Schablone abgedeckt wird. Die offenen Bereiche werden mittels UV-Strahlung belichtet und ausgehärtet. Anschließend kann eine dünne Metallisierung z. B. aufgesputtert werden und die nicht gehärteten Lackstrukturen können mittels Nasschemie oder verschiedener Plasmaprozesse entfernt werden. Bei der Schablonentechnik ist ein kontinuierlicher Rolle-Zu-Rolle-Betrieb mit einem bahnförmigen Substrat problematisch, da die Schablonen entweder als Rolle bzw. Zylinder ausgelegt sein müssen oder als diskontinuierlicher Teil in den Gesamtprozess integriert werden müssen.

Die kurz angesprochene Photoresist-Technik eignet sich besonders für die Herstellung von sehr dünnen, meist wenige µm Dicken metallischen. Strukturen, da die nicht gehärtete Lackschicht anschließend durch Auswaschen oder Plasmaätzen entfernt werden muss. Liegt die Beschichtung hingegen in einer großen Schichtdicke auf dem Photoresist, so kann dieser nicht mehr entfernt werden, da es nicht möglich ist, durch die vollflächige, geschlossene Beschichtung auf den Photoresist zuzugreifen.

DE3924716 A1 offenbart ein Verfahren zur Herstellung einer strukturierten Oberfläche auf einem Substrat mittels nichtthermischer Plasmabeschichtung umfassend: Maskierung des Negativ - Musters auf der Substratoberfläche mit Fotolack, Beschichtung der gesamten Substratoberfläche mit einer gewünschten Dicke von Gold oder Silber mittels Plasma und Ablösung des Verbundes von Plasmabeschichtung und Fotolack mittels eines Haftklebebandes. Nach der Ablösung des Verbundes von Plasmabeschichtung und Fotolack werden durch ein zusätzliches abtragendes Verfahren verbleibende Maskierungsreste entfernt.

Aufgabe der Erfindung ist es, ein Verfahren der eingangs genannten Art für hohe Schichtdicken, vorzugsweise im Bereich von 0,01 bis 1000 µm anzugeben, das als kontinuierlicher Prozess bzw. Prozess mit kurzen Taktzeiten realisierbar ist.

Diese Aufgabe wird durch ein Verfahren mit den Merkmalen des ersten Patentanspruches gelöst. Die Unteransprüche betreffen besonders vorteilhafte Weiterbildungen der Erfindung.

Der allgemeine erfinderische Gedanke liegt darin, die unterschiedliche Oberflächenhaftung zwischen Maskenmaterial und Substrat einerseits sowie Beschichtung und Substrat andererseits auszunutzen. Das erfindungsgemäße Verfahren besteht aus einem Maskierungsverfahren, einer nachfolgenden Plasmabeschichtung und einem wiederum nachfolgenden Ablösen der vorher maskierten Struktur. Die Maskierung selbst kann besonders vorteilhaft als Negativ über ein bekanntes Druckverfahren aufgebracht werden. Das Maskierungsmaterial besteht dabei aus einem Material mit einer geringen inneren Festigkeit. Dies können z. B. Öle, Wachse oder noch unvernetzte kurzkettige Polymere sein. Es eignen sich auch Maskierungsmaterialien, die spröde sind und beim Anlegen von Biegeschälkräften brechen, wie etwa getrocknete Salze. Die anschließende Plasmabeschichtung wird nachfolgend vollflächig aufgebracht und abgeblasen. Die wiederum nachfolgende Ablösung des Verbundes von Plasmabeschichtung und Maskierungsmaterial kann auf besonders vorteilhafte Weise mit einem Haftklebeband erfolgen, das unter einem definierten Druck auf die maskierte und beschichtete Oberfläche aufgebracht wird, wobei der Verbund aus Beschichtung und Maskenfarbe vom Substrat gelöst wird. Die Haftungskräfte sind dabei durch geeignete Materialwahl so einzustellen, dass die Plasmabeschichtung, die unmittelbar auf dem Substrat aufgebracht ist, eine stärkere Haftung zum Substrat als zum Haftklebeband aufweist. Damit ist verfahrensmäßig sichergestellt, dass nur die vorher maskierten Bereiche samt der darauf aufliegenden Beschichtung am Haftklebeband haften bleiben und mit diesem entfernt werden. Als positiver Nebeneffekt werden durch das Haftklebeband Pulverrückstände von der Oberfläche der auf dem Substrat verbleibenden Plasmabeschichtung entfernt. Es findet hierbei ein Bruch in der vollflächigen Plasmabeschichtung statt, der den vorher aufgebrachten Konturen folgt. Hierbei kann man die Beschichtungsparameter derart wählen, dass dünne Beschichtungen eher zäh sind und dicke Beschichtungen eher spröde sind. Hierdurch sowie durch die Kontur der Maskierung folgt das Bruchbild der Maskierung.

Nach dem Ablösen der Druckmaske, d. h. der Maskierung, können verbleibende Farbreste durch ein nachfolgendes Waschverfahren oder ein anderes abtragendes Verfahren entfernt werden.

Weiterhin ist es möglich, abschließend den erzeugten Verbund aus Substrat und Beschichtung mit einer Überlackierung zu versehen, um Pulverreste auf den erzeugten Strukturen, die nicht vollständig abgewaschen bzw. abgetragen worden sind, zu fixieren. Gleichzeitig bietet ein solcher Schutzlack eine Barriere gegen Luftsauerstoff und Luftfeuchtigkeit.

Im Rahmen der Erfindung ist es bei einem abgewandelten Verfahren auch möglich, zur Maskierung einen Schablonenprozess vorzusehen, bei dem zwischen Schablone und Substrat ein fließfähiges Medium - mit in Abhängigkeit von der Oberflächenvorbereitung großen oder kleinen Adhersionskräften - angeordnet ist, um das Eindringen des Beschichtungsmediums unter die Schablone zu verhindern. Beim Abheben der Schablone lässt sich dieses fließfähige Medium trennen. Nachfolgend wird wieder mittels Haftklebeband die Oberfläche der Struktur gereinigt. Unter dem Begriff "Haftklebeband" sind im Rahmen der Erfindung alle klebrigen Bänder mit einem Festigkeitsträger zu verstehen.

Das erfindungsgemäße Verfahren und zu seiner Durchführung besonders vorteilhafte Vorrichtungen sollen nachfolgend an Hand von Figuren beispielhaft noch näher erläutert werden.

Es zeigen:
- Figur 1: ein erfindungsgemäßes Verfahren in schematischer Darstellung der nacheinander ablaufenden wesentlichen Verfahrensschritte
- Figur 2: ein erfindungsgemäß erzeugtes bahnförmiges Substrat, und zwar
a) von oben
b) in seitlicher Schnittdarstellung
- Figur 3: eine geeignete Möglichkeit zur Durchführung des Verfahrensschrittes der Maskierung
- Figur 4: eine geeignete Möglichkeit der nachfolgenden vollflächigen Aktivierung/Beschichtung durch Plasmabeschichtung
- Figur 5: eine im Ergebnis einer solchen Beschichtung erzielte vollflächige Beschichtung auf dem Substrat
- Figur 6: eine Möglichkeit zur nachfolgenden Ablösung des Verbundes und Freilegung der gewünschten Struktur auf dem Substrat
- Figur 7: schematische Darstellungen des Ablöseprozesses im Einzelnen in Teilschritten a) bis e)
- Figur 8: eine Möglichkeit des nachfolgenden Versiegelns der erzeugten Gesamtstruktur mit Lack oder Farbe zum Schutz und zur Fixierung von verbliebenen Pulverresten in zwei nacheinander ablaufenden Verfahrensschritten a) und b)
- Figur 9: eine schematische Darstellung eines abgewandelten Verfahrens mit einer Schablone, wobei als besonderes Merkmal ein viskoser, fließfähiger Film aufgebracht wird, in einzelnen Verfahrensschritten a) bis b).

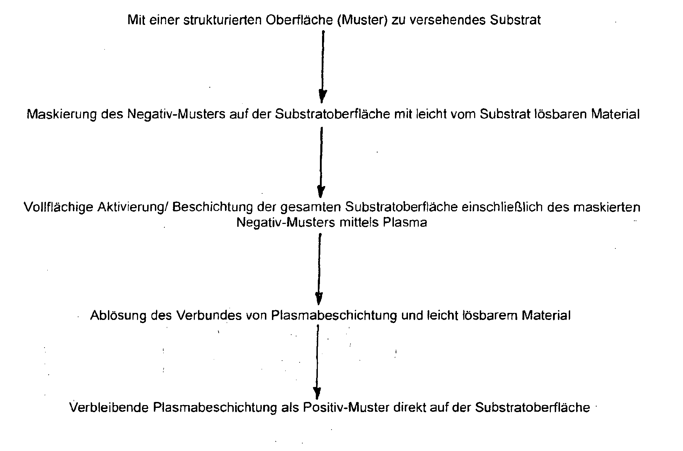

In Figur 1 sind die wesentlichen Schritte des erfindungsgemäßen Verfahrens schematisch zusammengefasst. Es ist dargestellt, dass zunächst auf der Substratoberfläche eine Maskierung des Negativ-Musters des später zu erzeugenden Musters mit leicht vom Substrat lösbarem Material erfolgt. Anschließend erfolgt eine vollflächige Aktivierung und/oder Beschichtung der gesamten Substratoberfläche einschließlich des maskierten Negativ-Musters mittels Plasma. Im Anschluss daran wird eine Ablösung des Verbundes von Plasmabeschichtung und leicht lösbarem Material vorgenommen; es verbleibt die Plasmabeschichtung als Positiv-Muster direkt auf der Substratoberfläche.

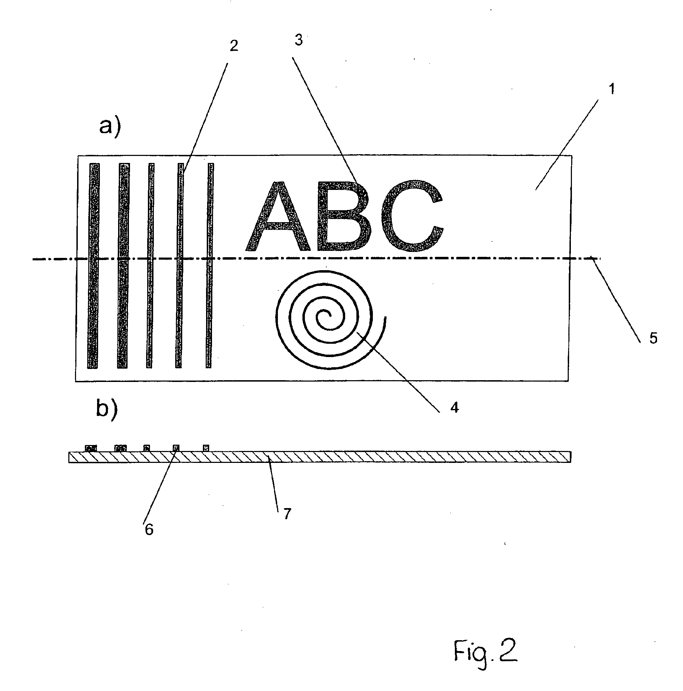

Figur 2 zeigt ein bahnförmiges Substrat 1 mit strukturierten Beschichtungen 2, 3, 4 auf der Oberfläche. Als Beschichtungsmaterial kommen sowohl organische Materialien wie Polymere als auch anorganische Materialien wie Keramik, Salze oder auch Metalle zum Einsatz. Die Beschichtungen können in Schichtdicken von 0,01 bis zu einigen 1000 µm hergestellt werden. Die Beschichtungsrate und Beschichtungscharakteristik kann über die Plasmaleistung und die Korngröße der jeweils verwendeten Beschichtungspulver variiert werden. Das Höhe-Breite-Verhältnis der Strukturen hängt ebenfalls von der Korngröße des Beschichtungspulvers ab.

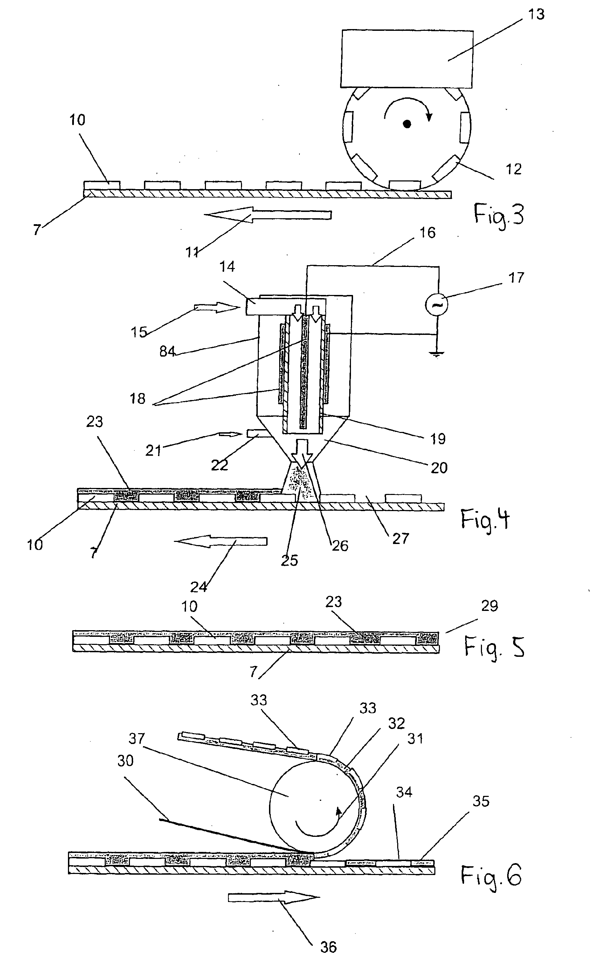

Figur 3 zeigt eine Möglichkeit zur Maskierung des Substrates vor der nachfolgenden Beschichtung. Dabei ist ein rotatives Bedrucken der Substratbahn 7 mittels Vertiefungen in einem Druckzylinder 12 gezeigt, in denen die Druckfarbe von einem Farbkasten 13 auf die Substratbahn 7 übertragen wird. Als Druckfarbe können Öle, Wachse, Polymere, UV-Farben o. ä. eingesetzt werden. Die Farbe darf jedoch nicht quervernetzen und somit verfestigt werden, da ansonsten der nachfolgende Ablöseprozess erschwert bzw. unmöglich wird.

Figur 4 zeigt eine Möglichkeit der nachfolgenden vollflächigen Plasmabeschichtung. Es ist ein Plasmaerzeuger 84 gezeigt, in den ein Prozessgas 15 über eine Zuführung 14 eingeleitet wird. Mittels einer Hochspannungsquelle 17, die über eine Zuleitung 16 am Plasmaerzeuger 84 angeschlossen ist, wird zwischen den Elektroden 18 und dem dazwischen angeordnetem Dielektrikum 19 ein Plasma gezündet. Das Plasma wird über die Strömungsrichtung 26 in die Austrittsöffnung 20 geführt und dort mit dem Beschichtungsmaterial bzw. -pulver vermischt. Dadurch wird das Beschichtungspulver 21, das über die Zuführung 22 in den Plasmaerzeuger geleitet wird, aktiviert, aufgeschmolzen und auf das Substrat gebracht. Dort bildet sich im Plasmastrahl eine flächige, geschlossene Beschichtung aus. Die Beschichtung legt sich über die Konturen der Maskierung und in die verbleibenden Bereiche dazwischen direkt auf das Substrat. Durch die Energie der aufgebrachten Pulverpartikel baut sich eine Haftung zwischen Substrat und Pulverpartikel auf. Das Substrat wird unter dem Plasmaerzeuger 84 in Bewegungsrichtung des Pfeiles 24 durchgeführt.

Figur 5 zeigt eine auf diese Weise erzielte vollflächige Beschichtung des Substrates 7 mit Beschichtungen auf der Maskierung 10 und Beschichtungen 23 zwischen der Maskierung.

Figur 6 zeigt den praktisch realisierten Verfahrensschritt der Ablösung des Verbundes. Ein Haftklebeband 30 wird über eine Andruckrolle 37 mit einem definierten Anpressdruck und mit der Haftseite hin zum Substrat auf dieses Substrat aufgepresst. Die Bahngeschwindigkeit ist an die Geschwindigkeit einer Anpressrolle 31 angepasst, so dass sich das Haftklebeband mit gleicher Geschwindigkeit bewegt. Durch die räumliche Umlenkung des Haftklebebandes entstehen Kräfte senkrecht zum Substrat, die zum partiellen Ablösung der Beschichtung führen. Da die Haftkraft des Haftklebebandes hier geringer ist als die Haftung der Beschichtung direkt auf dem Substrat, werden diese Bereiche der Beschichtung 35 nicht abgelöst. Hingegen werden die Bereiche der Maskierung vom Haftklebeband abgelöst, da, wie erläutert, die inneren Haftungskräfte des Maskierungsmaterials bzw. der Farbe geringer sind als die Haftkraft des Haftklebebandes. Das Maskierungsmaterial funktioniert wie eine "Sollbruchstelle". Teile des Materials inklusive Beschichtung 33 werden vom Haftklebeband abgelöst und abgeführt. Ein Farbrest 34 kann auf dem Substrat verbleiben.

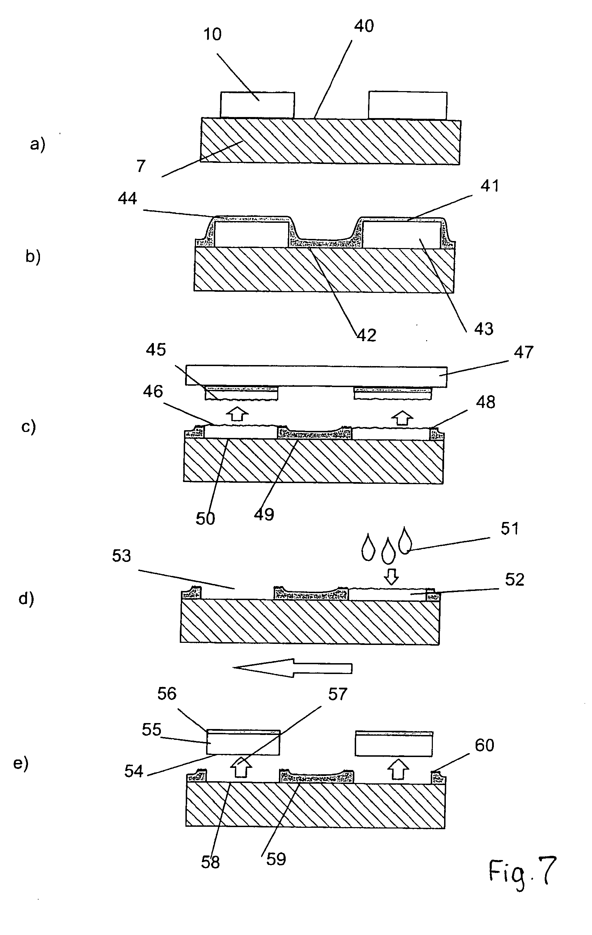

Figur 7 zeigt in schematischer Darstellung des Ablöseprozess in verschiedenen Phasen:
a) Ausgangssituation mit aufgedruckter Negativ-Maskierung
b) nach der Plasmabeschichtung mit der vollständigen Überdeckung der Maskierung
c) das Ablösen der Oberfläche mit Haftklebeband 47
d) das vorteilhafte Abwaschen der Farbreste mit Lösungsmittel 51 oder durch einen Plasmaätzprozess
e) das vollständige Ablösen der Maskierungsfarbe beim Abzugsprozess.

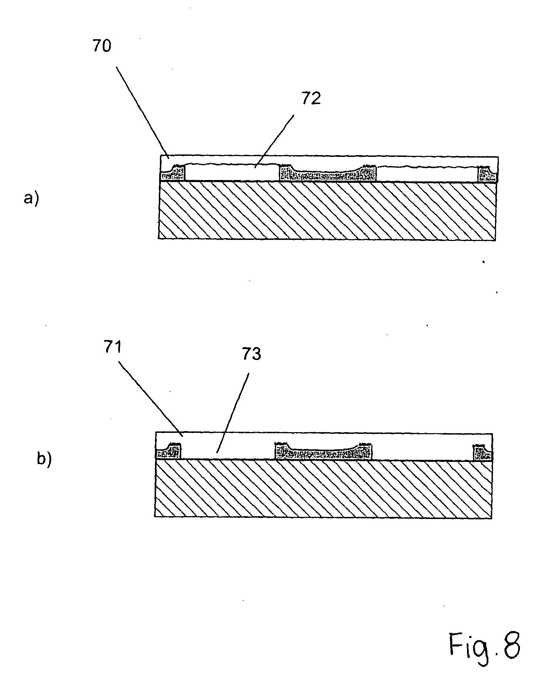

Figur 8 zeigt den vorteilhaften anschließenden Verfahrensschritt des Überdruckens der erzeugten Gesamtstruktur mit Lack oder Farbe zur Versiegelung und Einbindung von verbliebenen Pulverresten auf der Struktur.

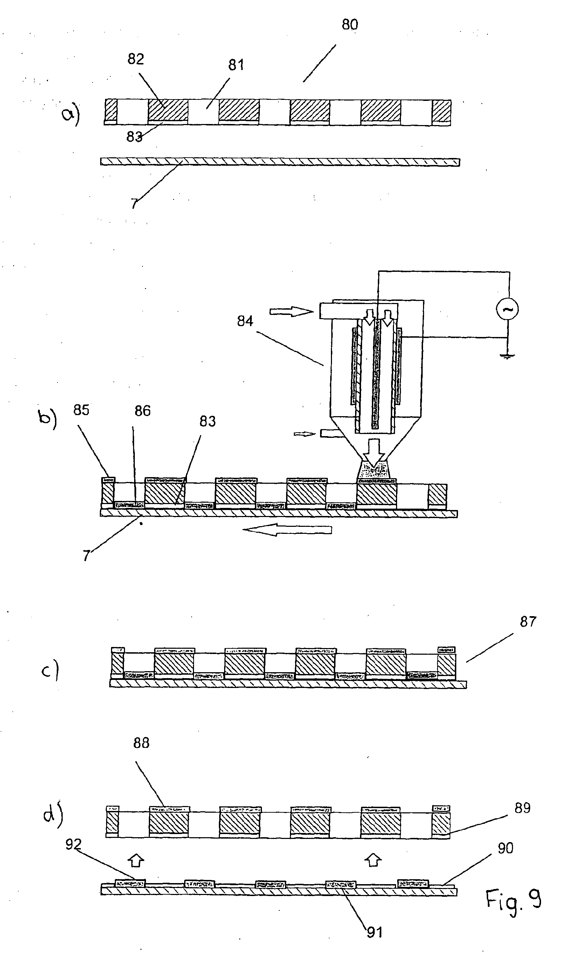

Figur 9 schließlich zeigt schematisch die Realisierung eines abgewandelten erfindungsgemäßen Verfahrens mit einer Schablone, wobei als besonderes Merkmal ein viskoser, fließfähiger Film zwischen Schablone und Substrat aufgebracht wird. Dieser Film verhindert das Eindringen von Pulver bei der nachfolgenden Plasmabeschichtung unter die Schablone. Beim Abziehen wird dieser Film zerteilt. Ein Teil wird mit der Schablone abgelöst, ein Teil verbleibt auf dem Substrat.

Wie eingangs bereits erläutert, gestatten die heute nach dem Stand der Technik verwendeten Verfahren mit ihren dicken Plasmabeschichtungen alleine schon wegen der Dicke und auch durch die hohen Auftragstemperaturen keinen gezielten Bruch am Rande der Maskierung. Dieser Nachteil wird durch das erfindungsgemäße Verfahren zuverlässig beseitigt.

### Bezugszeichenaufstellung

In den Figuren sind die nachfolgenden Bezugszeichen verwendet worden:
- 1: Flaches Substrat mit erhabener Struktur (Metall, Keramik, Kunststoff) auf der Oberseite
- 2: Strukturierung, z. B. Metall
- 3: Strukturierung, geschlossene Kontur
- 4: Feine Linienstruktur
- 5: Schnittlinie für Seitenansicht
- 6: Struktur im Querschnitt
- 7: Substrat (bogen- oder bahnförmig)
- 10: Gedruckte Struktur (Druckfarbe, Öl, Wasser, UV-Farbe)
- 11: Bewegungsrichtung Substrat
- 12: Druckwerk mit Vertiefungen
- 13: Farbwerk
- 14: Zuführung Prozessgas in Plasmaerzeuger
- 15: Prozessgas Strömungsrichtung
- 16: Elektrischer Anschluss Plasmaerzeuger
- 17: Spannungsquelle
- 18: Elektroden (Innen-/Außenelektrode)
- 19: Dielektrikum - Isolator
- 20: Austrittsdüse
- 21: Strömungsrichtung Beschichtungsmaterial
- 22: Eintritt Beschichtungsmaterial (Pulver, Aerosol)
- 23: Vollflächige Beschichtung
- 24: Bewegungsrichtung des Substrats unter dem Plasmaerzeuger
- 25: Austrittsstrahl (aktiviertes Pulver)
- 26: Strömungsrichtung aus Plasmaerzeuger
- 27: Bedrucktes Substrat vor der Beschichtung
- 29: Vollflächig beschichtetes Substrat
- 30: Klebeband (Unterseite klebend beschichtet), wird von Rolle zugeführt
- 31: Andruck- und Umlenkrolle
- 32: Abgelöste Beschichtung auf dem Klebeband, Beschichtungsmaterial
- 33: Abgelöste Beschichtung, Druckfarbe mit Beschichtung
- 34: Reste der Druckfarbe (Trennebene innerhalb der Druckfarbe)
- 35: Beschichtung, haftend auf Substratbahn
- 40: Nicht bedruckter Bereich zur Beschichtung
- 41: Beschichtung auf gedruckten Strukturen
- 42: Bereich der Haftung zwischen Substrat und Beschichtung
- 43: Druckfarbe
- 44: s. 41
- 45: Sollbruchstelle innerhalb der Druckfarbe beim Ablösen mit Klebeband, Haftung Beschichtung +1/2 Farbe am Klebeband
- 46: Sollbruchstelle auf dem Substrat, ein Rest der Druckfarbe bleibt haften
- 47: Klebeband, Unterseite haftend beschichtet
- 48: Sollbruchstelle im schwächsten Bereich der Beschichtung (Seitenwand-, Eckbereiche)
- 49: Haftverbund zwischen Substratoberfläche und Beschichtung
- 50: Verbliebene Druckfarbe auf dem Substrat
- 51: Wash-Off Verfahren zum Ablösen der Restdruckfarbe vom Substrat
- 52: Restdruckfarbe
- 53: Gereinigter Bereich ohne Druckfarbe
- 54: Sollbruchstelle zwischen Druckfarbe und Substrat (keine Haftung)
- 55: Komplett abgelöste Druckfarbe
- 56: Klebeband (Slug-Puller)
- 57: Abzugsrichtung
- 58: Bereich der abgelösten Druckfarbe ohne Beschichtung
- 59: Haftverbund zwischen Substrat und Beschichtung
- 60: Sollbruchstelle im schwächsten Bereich der Beschichtung (Seitenwand-, Eckbereiche)
- 70: Überlackierung der gesamten Struktur zur Fixierung (Lösemittellack, UV-Lack, Glob-Top)
- 72: Verbliebener Druckfarbenrest
- 73: Gereinigter Bereich zwischen den Beschichtungsstrukturen
- 80: Maskierungsverfahren mit Schablone
- 81: Durchbruch in Schablone
- 82: Stege in der Schablone
- 83: Fließfähiges Dichtmedium auf der Unterseite der Schablone (Öl, Wachs, Polymer)
- 84: Plasmaerzeuger mit Beschichtungsfunktion
- 85: Auf der Schablone abgeschiedene Beschichtung
- 86: Auf dem Substrat abgeschiedene Beschichtung
- 87: Schablone auf dem Substrat nach der Beschichtung
- 88: s.85
- 89: Getrenntes Dichtmedium an der Schablone haftend
- 90: Getrenntes Dichtmedium am Substrat haftend
- 91: Haftbereich der Beschichtungsstruktur auf dem Substrat nach Abheben der Schablone
- 92: Beschichtungsstruktur auf dem Substrat

## Patentansprüche

1. Verfahren zur Herstellung einer strukturierten Oberfläche, d. h. eines Musters auf einem Substrat mittels Plasmabeschichtung,
**aufweisend nachfolgende Verfahrensschritte:**
- Maskierung des Negativ-Musters auf der Substratoberfläche mit leicht vom Substrat lösbarem Material
- vollflächige Aktivierung/Beschichtung der gesamten Substratoberfläche einschließlich des maskierten Negativ-Musters mittels Plasma,
d. h. einem Plasmaerzeuger, in dem ein Prozessgas über eine Zuführung eingeleitet,
zwischen Elektroden ein Plasma gezündet,
das Plasma mit dem Beschichtungsmaterial vermischet
und der solcherart gemischte Plasmastrahl auf die Substratoberfläche gelenkt wird, derart, dass sich dort das Beschichtungsmaterial vollflächig mit einer Schichtdicke von 0,01 bis 5000 µm niederschlägt
- Ablösung des Verbundes von Plasmabeschichtung und leicht lösbarem Material mittels eines Haftklebebandes
- Erhalt der direkt auf dem Substrat haftenden verbleibenden Plasmabeschichtung als Muster
- Überlackierung des auf dem Substrat erhaltenen Musters, um Pulverreste zu fixieren und gleichzeitig eine Barriere gegen Luftsauerstoff und Luftfeuchtigkeit zu bilden.

2. Verfahren nach Anspruch 1,
**dadurch gekennzeichnet,**
**dass** als leicht vom Substrat lösbares Maskierungsmaterial Öle, Wachse oder kurzkettige Polymere verwendet werden.

3. Verfahren nach Anspruch 1,
**dadurch gekennzeichnet,**
**dass** als leicht vom Substrat lösbares Maskierungsmaterial nach der Maskierung austrocknende Salze verwendet werden.

4. Verfahren nach einem der Ansprüche 1 bis 3,
**dadurch gekennzeichnet,**
**dass** die Maskierung durch rotatives Bedrucken mittels Vertiefungen in einem Druckzylinder erfolgt, wobei die Druckfarben von einem Farbkasten auf die Substratbahn übertragen werden.

5. Verfahren nach Anspruch 4,
**dadurch gekennzeichnet,**
**dass** als Druckfarben Öle, Wachse, Polymere oder UV-Farben eingesetzt werden.

6. Verfahren nach einem der Ansprüche 1 bis 5,
**dadurch gekennzeichnet,**
**dass** als mittels Plasma aufzutragendes Beschichtungsmaterial organische Materialien, z. B. Polymere, verwendet werden.

7. Verfahren nach einem der Ansprüche 1 bis 6,
**dadurch gekennzeichnet,**
**dass** als mittels Plasma aufzutragendes Beschichtungsmaterial anorganische Materialien, z. B. Keramik, Salze oder Metall, verwendet werden.

8. Verfahren nach einem der Ansprüche 1 bis 7,
**dadurch gekennzeichnet,**
**dass** nach der Ablösung des Verbundes von Plasmabeschichtung und leicht lösbarem Material durch ein zusätzliches abtragendes Verfahren verbleibende Maskierungs- und/oder Beschichtungsreste entfernt werden.

9. Verfahren nach einem der Ansprüche 1 bis 8,
**dadurch gekennzeichnet,**
**dass** die Maskierung mittels einer Schablone als leicht vom Substrat lösbarem Material erfolgt,
**dass** nachfolgend eine viskoser, fließfähiger Film zwischen Schablone und Substrat aufgebracht wird und dass bei der Ablösung des Verbundes von Plasmabeschichtung und Schablone ein Teil dieses Filmes mit abgelöst wird, während der andere Teil auf dem Substrat verbleibt.

## Claims

1. Method of producing a structured surface, i.e. a pattern, on a substrate by means plasma coating,
comprising the following method steps:
- masking the negative pattern on the substrate surface by material easily detachable from the substrate,
- whole-area activation/coating of the entire substrate surface inclusive of the masked negative pattern by means of plasma, i.e. a plasma generator, into which a process gas is introduced by way of a feed, a plasma is ignited between electrodes, the plasma is mixed with the coating material and the thus-mixed plasma stream is guided onto the substrate surface in such a manner that the coating material deposits there over the whole area with a layer thickness of 0.01 to 5,000 microns,
- detaching the composite of plasma coating and easily detachable material by means of an adhesive strip,
- obtaining the plasma coating, which remains directly adhering to the substrate, as a pattern and
- lacquering over the pattern obtained on the substrate in order to fix powder residues and at the same time form a barrier against air oxygen and humidity.

2. Method according to claim 1, **characterised in that** oils, waxes or short-chain polymers are used as masking material easily detachable from the substrate.

3. Method according to claim 1, **characterised in that** salts which dry out after the masking are used as masking material easily detachable from the substrate.

4. Method according to any one of claims 1 to 3, **characterised in that** the masking is carried out by rotary printing by means of depressions in a printing cylinder, wherein the printing inks are transferred from an ink fountain to the substrate web.

5. Method according to claim 4, **characterised in that** oils, waxes, polymers or ultraviolet inks are used as printing inks.

6. Method according to any one of claims 1 to 5, **characterised in that** organic materials, for example polymers, are used as coating material to be applied by means of plasma.

7. Method according to any one of claims 1 to 6, **characterised in that** inorganic materials, for example ceramic, salts or metal, are used as coating material to be applied by means of plasma.

8. Method according to any one of claims 1 to 7, **characterised in that**, after detaching of the composite of plasma coating and easily detachable material, residual masking and/or coating residues are removed by an additional removal method.

9. Method according to any one of claims 1 to 8, **characterised in that** the masking is carried out by means of a template as material easily detachable from the substrate, that subsequently a viscous, flowable film is applied between the template and substrate and that in the detaching of the composite of plasma coating and template a part of this film is detached therewith whilst the other part remains on the substrate.

## Revendications

1. Procédé d'obtention d'une surface structurée, c'est-à-dire d'un modèle sur un substrat par revêtement plasma comportant les étapes consistant à :
- masquer le négatif du modèle sur la surface du substrat avec un matériau pouvant facilement être détaché du substrat,
- activer/revêtir la totalité de la surface du substrat y compris le négatif du modèle masqué au moyen de plasma,
c'est-à-dire d'un générateur de plasma dans lequel un gaz de process est introduit par une entrée,
un plasma est activé entre des électrodes,
le plasma est mélangé avec le matériau de revêtement, et
le rayonnement plasma ainsi mélangé est dévié sur la surface du substrat de façon à précipiter le matériau de revêtement sur la totalité de cette surface avec une épaisseur de couche de 0,01 à 5000 µm,
- détacher la liaison du revêtement plasma et du matériau facilement détachable au moyen d'une bande d'adhésif,
- obtention du revêtement plasma restant adhérant directement sur le substrat en tant que modèle,
- faire un revernissage du modèle obtenu sur le substrat pour fixer des résidus de poudre et former simultanément une barrière contre l'oxygène de l'air et l'humidité.

2. Procédé conforme à la revendication 1,
**caractérisé en ce qu'**
on utilise en tant que matériau de masquage pouvant facilement être détaché du substrat des huiles, des cires ou des polymères à chaine courte.

3. Procédé conforme à la revendication 1,
**caractérisé en ce qu'**
on utilise en tant que matériau de masquage pouvant facilement être détaché du substrat des sels séchant après l'étape de masquage.

4. Procédé conforme à l'une des revendications 1 à 3,
**caractérisé en ce que**
le masquage s'effectue par impression rotative au moyen d'empreintes réalisées dans un cylindre de pression, les encres d'impression étant transférées sur le substrat à partir d'un encrier.

5. Procédé conforme à la revendication 4,
**caractérisé en ce qu'**
on utilise en tant qu'encre d'impression des huiles, des cires, des polymères ou des colorants UV.

6. Procédé conforme à l'une des revendications 1 à 5,
**caractérisé en ce qu'**
en tant que matériau de revêtement destiné à être appliqué au moyen de plasma on utilise des matériaux organiques par exemple des polymères.

7. Procédé conforme à l'une des revendications 1 à 6,
**caractérisé en ce qu'**
en tant que matériau de revêtement destiné à être appliqué au moyen de plasma on utilise des matériaux non organiques par exemple des céramiques, des sels ou des métaux.

8. Procédé conforme à l'une des revendications 1 à 7,
**caractérisé en ce qu'**
après avoir détaché la liaison du revêtement plasma et du matériau pouvant facilement être détaché, on élimine les résidus de masquage et/ou de revêtement résiduels par un procédé de séparation supplémentaire.

9. Procédé conforme à l'une des revendications 1 à 8,
**caractérisé en ce que**
l'on effectue le masquage au moyen d'un pochoir constituant le matériau pouvant facilement être détaché du substrat, on applique ensuite un film fluide visqueux entre le pochoir et le substrat et, lors de la séparation de la liaison du revêtement plasma et du pochoir on enlève une partie de ce film tandis que l'autre partie de celui-ci reste sur le substrat.
